# EUROPEAN PATENT SPECIFICATION

(11) **EP 0 517 560 B1**
(45) Date of publication and mention of the grant of the patent: **02.04.1997**
(21) Application number: 92401374.1
(22) Date of filing: 20.05.1992
(51) Int. Cl.: H01L 39/24, H01L 39/14

(54) **Method of manufacturing a superconducting microwave component substrate**
Verfahren zum Herstellen eines Substrats für supraleitende Mikrowellen-Komponenten
Méthode de fabrication d'un substrat utilisé dans un dispositif micro-ondes supraconducteur

(30) Priority: 20.05.1991 JP 144023/91
(43) Date of publication of application: 09.12.1992
(73) Proprietor: Sumitomo Electric Industries, Ltd., Osaka 541 (JP)
(72) Inventor: Matsuura, Takashi, c/o Itami Works of Sumitomo, Itami-shi, Hyogo (JP); Higaki, Kenjiro, c/o Itami Works of Sumitomo, Itami-shi, Hyogo (JP); Itozaki, Hideo, c/o Itami Works of Sumitomo, Itami-shi, Hyogo (JP)
(74) Representative: Bouget, Lucien

(56) References cited:
- EP-A- 0 435 765
- SOLID STATE TECHNOLOGY, vol. 33, no. 8, August 1990, Tulsa US, pp. 83-87; R.S. WITHERS et al.: 'High-Tc Superconducting Thin Films for Microwave Applications'
- APPLIED PHYSICS LETTERS, vol. 57, no. 8, 20 August 1990, New York US, pp. 825-827; R.B. HAMMOND et al.: 'Epitaxial T12CaBa2Cu2O8 thin films with low 9.6 GHz surface resistance at high power and above 77 K'
- JAPANESE JOURNAL OF APPLIED PHYSICS, vol. 30, no. 4B, 15 April 1991, Tokyo JP, pp. L700-L702; A. TANAKA et al.: 'High-Frequency Transmission through Bi-Sr-Ca-Cu-O Double-Sided Microstripline on an Mgo Substrate'

## Description

The present invention relates to a method for manufacturing a substrate for a superconducting microwave component, and more specifically to a novel method for manufacturing a substrate which can be suitably used in fabricating a microwave component having a conductor formed of an oxide superconducting thin film.

Electromagnetic waves called "microwaves" or "millimetric waves" having a wavelength in a range of a few tens centimeters to a few millimeters can be theoretically said to be merely a part of an electromagnetic wave spectrum, but have been considered from a viewpoint of an electric engineering to be a special independent field of the electromagnetic wave, since special and unique methods and devices have been developed for handling these electromagnetic waves.

On the other hand, in 1986, Bednorz and Müller reported (La, Ba)₂CuO₄ showing a superconducting state at a temperature of 30 K. In 1987, Chu reported YBa₂Cu₃O_{y} having a superconducting critical temperature on the order of 90 K, and in 1988, Maeda reported a so-call bismuth (Bi) type compound oxide superconducting material having a superconducting critical temperature exceeding 100 K. These compound oxide superconducting materials can obtain a superconducting with cooling using an inexpensive liquid nitrogen. As a result, possibility of actual application of the superconductor technology has become discussed and studied.

Phenomenon inherent to the superconduction can be advantageously utilized in various applications, and the microwave components are no exceptions. For example, a microstrip line has an attenuation coefficient that is attributable to a resistance component of the conductor. This attenuation coefficient attributable to the resistance component increases in proportion to a root of a frequency. On the other hand, the dielectric loss increases in proportion to increase of the frequency. However, the loss of a recent microstrip line particularly in the range of not greater than 10 GHz is almost attributable to the resistance of the conductor, since the dielectric materials have been recently improved. Therefore, if the resistance of the conductor in the strip line can be reduced, it is possible to greatly elevate the performance of the microstrip line.

As well known, the microstrip line can be used as a simple signal transmission line. However, if a suitable patterning is applied, the microstrip line can be used as other microwave components including an inductor, a filter, a resonator, and a delayed line. Therefore, improvement of the microstrip line will directly result in improvement of characteristics of these microwave components. Under this circumstance, various microwave devices having a conductor line or lines formed of oxide superconductors have been proposed.

Here, a microwave transmission line for guiding the electromagnetic waves in the microwave band is generally formed of a pair of conductors separated from each other by a dielectric, one of the pair of conductors being grounded.

For example, a substrate which can be suitably used in fabricating the above mentioned microwave transmission line is formed of a dielectric substrate as an underlying substrate and a pair of oxide superconductor thin films formed on an upper surface and a lower surface of said underlying substrate, respectively. If this substrate is given or available, various superconduction microwave components can be easily fabricated by suitably patterning one of the pair of oxide superconductor thin films formed on the upper and lower surfaces of said underlying substrate, respectively.

However, a problem has been encountered in forming the above mentioned substrate for the microwave component, by a process of depositing an oxide superconductor thin film on one surface of a dielectric substrate, and thereafter depositing another oxide superconductor thin film on the other surface of the dielectric substrate.

The reason for this is as follows: First, the oxide superconductor thin film can be obtained only when a film of oxide superconductor material is deposited on a specific substrate under a specific deposition condition. Secondly, since oxygen contained in the oxide superconductor material is unstable, if the deposited oxide superconductor material is heated, the content of the oxygen will change. Therefore, in the process of sequentially depositing an oxide superconductor thin film on one or first surface of a dielectric substrate, and thereafter on the other or second surface of the dielectric substrate, the superconductor characteristics of the oxide superconductor thin film deposited on the first surface of a dielectric substrate is deteriorated or lost when the oxide superconductor thin film is deposited on the second surface of a dielectric substrate. Because of this, it has been considered difficult to prepare a substrate for microwave component having superconductor thin film of uniform characteristics formed on opposite surfaces of the dielectric substrate.

In Applied Physics letters, vol 57, n° 8, 20 August 1990, p.p. 825-827, it has been proposed a method to produce low-loss passive microwave devices comprising the steps of forming an epitaxial Tl-Ba-Ca-Cu-O thin film on a surface of a chemically polished single cristalline LaAlO₃ low-loss microwave substrate and annealing said film for several minutes at high temperature (830-900°C) under controlled thallium-oxygen pressure. The document does not pertain to the art of producing a substrate for a superconducting microwave component having two opposed thin films of oxide formed on two opposed surfaces of an underlying substrate and does not suggest an annealing treatment which could apply to a such substrate with two opposed superconductor oxide thin films.

In Japanese Journal of Applied Physics, vol. 30, n° 4B, April 1991, p.p. L700-702, is described and show a microstripline having superconducting Bi-Sr-Ca-Cu-O line and groundplane formed on a dielectric MgO substrate. The high-Tc phase of Bi-Sr-Ca-Cu-O is considered as having several advantages over other materials such as yttrium-based material.

Accordingly, it is an object of the present invention to provide a method for fabricating a substrate for a superconducting microwave component, which method overcomes the problems of the above mentioned prior art.

Another object of the present invention is to provide a novel method for fabricating a substrate for a superconducting microwave component having oxide superconductor material thin films which are formed on opposite surfaces of an underlying substrate and which can exert effective superconducting characteristics.

The above and other objects of the present invention are achieved in accordance with the present invention by a method of manufacturing a substrate of a superconducting microwave component, the substrate being composed of an underlying substrate (1) including a dielectric layer, and a pair of oxide superconductor thin films (2a, 2b) formed on an upper surface and a lower surface of said underlying substrate, respectively, the method including the steps of forming a first Tl-Ba-Ca-Cu-O compound oxide thin film (2a) on one surface of said underlying substrate (1), forming a second Tl-Ba-Ca-Cu-O compound oxide thin film (2b) on the other surface of said underlying substrate (1), and annealing said underlying substrate (1) having a pair of surfaces coated with said Tl-Ba-Ca-Cu-O compound oxide thin films (2a, 2b), in an oxygen atmosphere containing not less than 5 mol % of thallium for a time in the range of one hour to three hours inclusive in the temperature range of 850°C to 900°C inclusive, thereby to recover the superconducting characteristics of the first oxide superconductor thin film (2a) deposited on said one surface of said underlying substrate (1) which had been deteriorated or lost when said second oxide superconductor thin film (2b) was deposited on said other surface of said underlying substrate (1), and also to cause said first and second Tl-Ba-Ca-Cu-O compound oxide thin films (2a, 2b) to have substantially the same superconducting characteristics.

As seen from the above, the method in accordance with the present invention for manufacturing a substrate of a superconducting microwave component is characterized in that after the Tl-type compound oxide thin films are formed on the opposite surfaces of the underlying substrate, respectively, the formed Tl-type compound oxide thin films are annealed in the thallium atmosphere.

As mentioned hereinbefore, in the conventional process of sequentially depositing an oxide superconductor thin film on a first surface of an underlying substrate, and thereafter on the second surface of the underlying substrate, the deterioration of the superconductor characteristics of the oxide superconductor thin film deposited on the first surface of the underlying substrate is inevitable in the step of depositing the oxide superconductor thin film on the second surface of the underlying substrate.

On the other hand, in the method in accordance with the present invention, since the Tl-type compound oxide is used as the oxide superconductor material, it is possible to perform the process for finally restoring the characteristics of the pair of oxide superconductor thin film.

Namely, it is possible to deposit the Tl-type oxide superconducting thin films at an extremely low substrate temperature on the order of a room temperature. Therefore, in the case that an oxide superconducting thin film is formed on one surface of the underlying substrate and thereafter on the other surface of the underlying substrate, the deterioration of the firstly deposited thin film can be minimized.

In addition, if the deposited Tl-type oxide superconducting thin film is annealed in the thallium atmosphere, the quality of the film can be improved.

Thus, after the Tl-type oxide superconducting thin films are formed on the opposite surfaces of the underlying substrate, respectively, if the deposited Tl-type oxide superconducting thin films are annealed in the thallium atmosphere, not only the quality of the pair of Tl-type oxide superconducting thin films can be improved, but also the film characteristics of the pair of thin films can be brought into substantially the same.

The annealing is conducted in an oxygen atmosphere containing not less than 5 mol % of thallium. If the content of the thallium is less than 5 mol %, an effective improvement of the film quality due to the annealing cannot be obtained. In this connection, it is considered that when the thallium is contained in the annealing oxygen atmosphere, the thallium exists in the form of thallium oxide.

In addition, the annealing temperature is in the range of 850°C to 900°C inclusive. If the annealing temperature is lower than this temperature range, a valid annealing effect cannot be obtained. If the annealing temperature is higher than this temperature range, the film quality of the thin film is rather deteriorated due to the annealing heat.

Furthermore, the annealing period of time is in the range of one hour to three hours inclusive. If the annealing time is shorter than this range, a valid annealing effect cannot be obtained. If the annealing time is longer than this range, the film quality of the thin film is rather deteriorated due to the annealing heat.

The underlying substrate should be formed of a dielectric material which has a small dielectric loss and which makes it possible to deposit the oxide superconductor thin film thereon in a good condition. LaAlO₃, NdGaO₃ and MgO can be exemplified. In addition, it is further preferred to use a substrate obtained by forming, on opposite surfaces of a dielectric plate such as a sapphire and SiO₂ having an extremely small dielectric loss, a buffer layer which makes it possible to deposit the oxide superconductor material in a good condition

The above and other objects, features and advantages of the present invention will be apparent from the following description of preferred embodiments of the invention with reference to the accompanying drawings. However, the examples explained hereinafter are only for illustration of the present invention, and therefore, it should be understood that the present invention is in no way limited to the following examples.

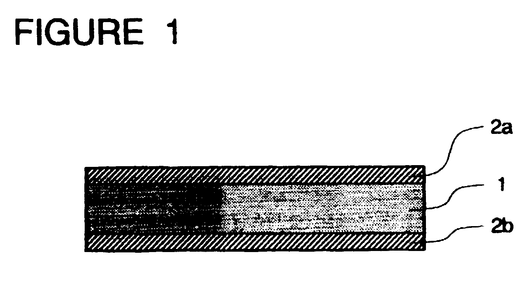

Figure 1 is a diagrammatic sectional view illustrating a basic construction of the substrate for the superconducting microwave component.

Referring to Figure 1, the substrate for the superconducting microwave component includes a dielectric underlying substrate 1 and a pair of oxide superconducting thin films 2a and 2b deposited on opposite surfaces of the underlying substrate 1, respectively.

### Example 1

The superconducting microwave component substrate having the above mentioned construction was manufactured in accordance with the method of the present invention.

A LaAlO₃ substrate having a thickness of 0.5 mm, a width of 15 mm and a length of 15 mm was used as the dielectric substrate. An oxide superconducting thin film was deposited by sputtering. The deposition condition was as follows:

| | |
|---|---|
| Target : | Tl₂Ba₂Ca_{2.5}Cu₃Oy |
| Sputtering gas : | Ar containing 20 mol % of O₂ |
| Gas pressure : | 6,7 Pa (50 mTorr) |
| Substrate Temperature : | 50 °C |
| Film thickness : | 10000 Å |

A pair of oxide superconducting thin films were continuously deposited on opposite surfaces of the dielectric substrate, respectively, in the same deposition chamber without taking the substrate out of the deposition chamber.

Thereafter, the substrate having the opposite surfaces coated with the oxide superconducting thin films, respectively was annealed in a thallium atmosphere. The annealing condition was as follows:

| | |
|---|---|
| Atmosphere : | O₂ gas containing 10 mol % of Tl |
| Gas pressure : | 10⁵ Pa (1 atm) |
| Annealing Temperature : | 870 °C |
| Annealing Time : | 1 hour |

In the thus formed substrate for microwave component, the characteristics of the oxide superconductor thin film formed on each of the opposite surfaces was measured. The result of the measurement is shown in the following:

| | Critical temperature (K) | Critical current density (A/cm²) |
|---|---|---|
| First surface (upper) | 104 | 1,4 × 10⁵ |
| Second surface (lower) | 102 | 1,2 × 10⁵ |

As seen from the above, in the substrate for microwave component fabricated in accordance with the method of the present invention, the oxide superconductor thin films respectively formed on the opposite surfaces of the underlying substrate have a substantially uniform superconduction characteristics. Incidentally, the critical current density was measured at 77 K.

### Comparative Example 1

For comparison, another substrate for microwave component was manufactured by using the same dielectric substrate as that of Example 1, and using an Y-Ba-Cu-O type compound oxide superconducting thin film material. The Y-Ba-Cu-O type compound oxide superconducting thin film was deposited by a sputtering. The deposition condition was as follows:

| | |
|---|---|
| Target : | Y₁Ba₂Cu₃Oy |
| Sputtering gas : | Ar containing 20 mol % of O₂ |
| Gas pressure : | 66,6 Pa (0.5 Torr) |
| Substrate Temperature : | 620 °C |
| Film thickness : | 4000 Å |

In the thus formed comparative example of the substrate for microwave component, the characteristics of the oxide superconductor thin film formed on each of the opposite surfaces was measured. The result of the measurement is shown in the following:

| | Critical temperature (K) | Critical current density (A/cm²) |
|---|---|---|
| First surface (upper) | 83 | 1 × 10⁵ |
| Second surface (lower) | 60 | ---------- |

As seen from the above, in the comparative example, the oxide superconductor thin film formed on the first surface of the underlying substrate was remarkably deteriorated in characteristics. Incidentally, the critical current density was measured at 77 K.

### Comparative Example 2

For comparison, a substrate for microwave component was manufactured in the same process as that of Example 1, excluding the annealing condition.

Thereafter, the substrate thus manufactured was annealed in a thallium atmosphere under the following annealing condition:

| | |
|---|---|
| Atmosphere : | O₂ gas containing 10 mol % of Tl |
| Gas pressure : | 10⁵ Pa (1 atm) |
| Annealing Temperature : | 950 °C |
| Annealing Time : | 2 hours |

In the thus formed substrate for microwave component, the characteristics of the oxide superconductor thin film formed on each of the opposite surfaces was measured. The critical current density was measured at 77 K. The result of the measurement is shown in the following:

| | Critical temperature (K) | Critical current density (A/cm²) |
|---|---|---|
| First surface (upper) | 70 | ----------- |
| Second surface (lower) | 75 | ----------- |

The above mentioned deterioration of the characteristics is considered to be attributable to that the thallium contained in the oxide superconductor thin films is evaporated.

### Comparative Example 3

For comparison, a substrate for microwave component was manufactured in the same process as that of Example 1, excluding the annealing condition.

Thereafter, the substrate thus manufactured was annealed in a thallium atmosphere under the following annealing condition:

| | |
|---|---|
| Atmosphere : | O₂ gas containing 10 mol % of Tl |
| Gas pressure : | 10⁵ Pa (1 atm) |
| Annealing Temperature : | 800 °C |
| Annealing Time : | 2 hours |

In the thus formed substrate for microwave component, the characteristics of the oxide superconductor thin film formed on each of the opposite surfaces was measured. The critical current density was measured at 77 K. The result of the measurement is shown in the following:

| | Critical temperature (K) | Critical current density (A/cm²) |
|---|---|---|
| First surface (upper) | 55 | ----------- |
| Second surface (lower) | 57 | ----------- |

The above mentioned deterioration of the characteristics is considered to be attributable to that the oxide superconductor thin films are not sufficiently crystallized.

### Comparative Example 4

For comparison, a substrate for microwave component was manufactured in the same process as that of Example 1, excluding the annealing condition.

Thereafter, the substrate thus manufactured was annealed in a thallium atmosphere under the following annealing condition:

| | |
|---|---|
| Atmosphere : | O₂ gas containing 10 mol % of Tl |
| Gas pressure : | 10⁵ Pa (1 atm) |
| Annealing Temperature : | 900 °C |
| Annealing Time : | 5 hours |

In the thus formed substrate for microwave component, the characteristics of the oxide superconductor thin film formed on each of the opposite surfaces was measured. The critical current density was measured at 77 K. The result of the measurement is shown in the following:

| | Critical temperature (K) | Critical current density (A/cm²) |
|---|---|---|
| First surface (upper) | 76 | ----------- |
| Second surface (lower) | 72 | ----------- |

The above mentioned deterioration of the characteristics is considered to be attributable to that the thallium contained in the oxide superconductor thin films is evaporated.

### Comparative Example 5

For comparison, a substrate for microwave component was manufactured in the same process as that of Example 1, excluding the annealing condition.

Thereafter, the substrate thus manufactured was annealed in a thallium atmosphere under the following annealing condition:

| | |
|---|---|
| Atmosphere : | O₂ gas containing 10 mol % of Tl |
| Gas pressure : | 10⁵ Pa (1 atm) |
| Annealing Temperature : | 900 °C |
| Annealing Time : | 0.5 hours |

In the thus formed substrate for microwave component, the characteristics of the oxide superconductor thin film formed on each of the opposite surfaces was measured. The critical current density was measured at 77 K. The result of the measurement is shown in the following:

| | Critical temperature (K) | Critical current density (A/cm²) |
|---|---|---|
| First surface (upper) | 45 | ----------- |
| Second surface (lower) | 42 | ----------- |

The above mentioned deterioration of the characteristics is considered to be attributable to that the oxide superconductor thin films are not sufficiently crystallized.

### Comparative Example 6

For comparison, a substrate for microwave component was manufactured in the same process as that of Example 1, excluding the annealing condition.

Thereafter. the substrate thus manufactured was annealed in a thallium atmosphere under the following annealing condition:

| | |
|---|---|
| Atmosphere : | O₂ gas containing 4 mol % of Tl |
| Gas pressure : | 10⁵ Pa (1 atm) |
| Annealing Temperature : | 870 °C |
| Annealing Time : | 1 hour |

In the thus formed substrate for microwave component, the characteristics of the oxide superconductor thin film formed on each of the opposite surfaces was measured. The critical current density was measured at 77 K. The result of the measurement is shown in the following:

| | Critical temperature (K) | Critical current density (A/cm²) |
|---|---|---|
| First surface (upper) | 65 | ----------- |
| Second surface (lower) | 68 | ----------- |

The above mentioned deterioration of the characteristics is considered to be attributable to that the thallium contained in the oxide superconductor thin films is evaporated.

As seen from the above, according to the method of the present invention, it is possible to manufacture a superconducting microwave component substrate having a pair of good oxide superconducting thin films which are formed on opposite surfaces of a single dielectric substrate and which are substantially the same in superconducting characteristics.

Therefore, the substrate manufactured in accordance with the method of the present invention can be used for fabricating various microwave components, by suitably patterning one of the pair of good oxide superconducting thin films. The microwave components thus obtained has a conductor formed of the superconductor, and therefore, has a small propagation loss and a wide application frequency band.

The invention has thus been shown and described with reference to the specific embodiments. However, it should be noted that the present invention is in no way limited to the details of the illustrated structures but changes and modifications may be made within the scope of the appended claims.

## Claims

1. A method of manufacturing a substrate of a superconducting microwave component, the substrate being composed of an underlying substrate (1) including a dielectric layer, and a pair of oxide superconductor thin films (2a, 2b) formed on an upper surface and a lower surface of said underlying substrate, respectively, the method including the steps of forming a first Tl-Ba-Ca-Cu-O compound oxide thin film (2a) on one surface of said underlying substrate (1), forming a second Tl-Ba-Ca-Cu-O compound oxide thin film (2b) on the other surface of said underlying substrate (1), and annealing said underlying substrate (1) having a pair of surfaces coated with said Tl-Ba-Ca-Cu-O compound oxide thin films (2a, 2b), in an oxygen atmosphere containing not less than 5 mol % of thallium for a time in the range of one hour to three hours inclusive in the temperature range of 850°C to 900°C inclusive, thereby to recover the superconducting characteristics of the first oxide superconductor thin film (2a) deposited on said one surface of said underlying substrate (1) which had been deteriorated or lost when said second oxide superconductor thin film (2b) was deposited on said other surface of said underlying substrate (1), and also to cause said first and second Tl-Ba-Ca-Cu-O compound oxide thin films (2a, 2b) to have substantially the same superconducting characteristics.

2. A method as claimed in claim 1, characterized in that the underlying substrate (1) is formed of a material selected from the group consisting of LaAlO₃, NdGaO₃ and MgO.

3. A method as claimed in claim 1, characterized in that the underlying substrate (1) is formed of a material selected from the group consisting of sapphire and SiO₂, said underlying substrate (1) having on opposite surfaces thereof a buffer layer which makes it possible to deposit the oxide superconductor material in a good condition.

4. A method as claimed in claim 1, characterized in that the first Tl-Ba-Ca-Cu-O compound oxide thin film (2a) formed on the first surface of the underlying substrate (1) and the second Tl-Ba-Ca-Cu-O compound oxyde thin film (2b) formed on the second surface of the underlying substrate (2) are continuously deposited by sputtering at an extremely low substrate temperature in the same deposition chamber without taking said underlying substrate out of the deposition chamber.

## Patentansprüche

1. Verfahren zum Herstellen eines Substrats für supraleitende Mikrowellen-Komponenten, wobei das Substrat aus einem Basissubstrat (1) mit einer dielektrischen Schicht und einem Paar von supraleitenden Oxid-Dünnschichten (2a, 2b) auf der oberen bzw. der unteren Oberfläche des Basissubstrates gebildet ist, wobei das Verfahren die Schritte umfaßt: Ausbilden einer ersten Oxid-Dünnschicht (2a) einer Tl-Ba-Ca-Cu-O-Verbindung auf einer Oberfläche des Basissubstrates, Ausbilden einer zweiten Oxid-Dünnschicht einer Tl-Ba-Ca-Cu-O-Verbindung auf der anderen Oberfläche des Basissubstrates und Glühen des Basissubstrates mit den zwei mit den genannten Oxid-Dünnschichten (2a, 2b) der Tl-Ba-Ca-Cu-O-Verbindung bedeckten Oberflächen in einer Sauerstoffatmosphäre, die nicht weniger als 5 Molprozent Thallium enthält, für eine Zeit im Bereich von einer bis drei Stunden inklusiv bei einer Temperatur im Bereich zwischen 850°C bis 900°C inklusiv, um dadurch die supraleitenden Eigenschaften der ersten, auf der einen Oberfläche des Basissubstrates abgelegten supraleitenden Oxid-Dünnschicht (2a) wiederherzustellen, die verschlechtert wurden oder verloren gingen, als die zweite supraleitende Oxid-Dünnschicht (2b) auf der anderen Oberfläche des Basissubstrates abgelegt wurde, und auch um dadurch die erste und zweite Oxid-Dünnschicht (2a, 2b) der Tl-Ba-Ca-Cu-O-Verbindung so zu beeinflussen, daß sie im wesentlichen die gleichen supraleitenden Eigenschaften haben.

2. Verfahren nach Anspruch 1, dadurch gekennzeichnet, daß das Basissubstrat (1) aus einem Material gebildet ist, das aus der Gruppe aus LaAlO₃, NdGaO₃ und MgO ausgewählt ist.

3. Verfahren nach Anspruch 1, dadurch gekennzeichnet, daß das Basissubstrat aus einem Material gebildet ist, das aus der Gruppe aus Saphir und SiO₂ ausgewählt ist, wobei das Basissubstrat (1) auf gegenüberliegenden Oberflächen eine Pufferschicht aufweist, welche es möglich macht, das supraleitende Oxidmaterial in gutem Zustand abzulegen.

4. Verfahren nach Anspruch 1, dadurch gekennzeichnet, daß die erste Oxid-Dünnschicht (2a) der Tl-Ba-Ca-Cu-O-Verbindung, die auf der ersten Oberfläche des Basissubstrates ausgebildet ist, und die zweite Oxid-Dünnschicht (2b) der Tl-Ba-Ca-Cu-O-Verbindung, die auf der zweiten Oberfläche des Basissubstrates (1) ausgebildet ist, kontinuierlich durch Sputtern bei einer extrem niedrigen Substrattemperatur in der gleichen Beschichtungskammer aufgebracht werden, ohne das Basissubstrat aus der Beschichtungskammer herauszunehmen.

## Revendications

1. Procédé de fabrication d'un substrat pour composant micro-ondes supraconducteur, le substrat étant composé d'un substrat sous-jacent (1) comprenant une couche diélectrique, et de deux couches minces supraconductrices d'oxyde (2a, 2b) formées sur la surface supérieure et sur la surface inférieure dudit substrat sous-jacent, respectivement, le procédé consistant à former une première couche mince (2a) d'oxyde composite Tl-Ba-Ca-Cu-O sur une première surface du substrat sous-jacent (1), à former une deuxième couche mince (2b) d'oxyde composite de Tl-Ba-Ca-Cu-O sur l'autre surface dudit substrat sous-jacent (1), et à recuire ledit substrat sous-jacent (1) comportant deux surfaces revêtues desdites couches minces (2a, 2b) d'oxyde composite de Tl-Ba-Ca-Cu-O dans une atmosphère d'oxygène ne contenant pas moins de 5 moles % de thallium pendant une période allant d'une heure à trois heures inclusivement, dans une plage de température de 850 à 900°C inclusivement, de manière à restaurer les caractéristiques supraconductrices de la première couche mince (2a) supraconductrice d'oxyde déposée sur ladite première surface dudit substrat sous-jacent (1) qui ont été dégradées ou perdues lorsque ladite deuxième couche mince (2b) supraconductrice d'oxyde a été déposée sur ladite autre surface dudit substrat sous-jacent (1), et également pour amener lesdites première et deuxième couches minces (2a, 2b) d'oxyde composite de Tl-Ba-Ca-Cu-O à avoir sensiblement les mêmes caractéristiques supraconductrices.

2. Procédé selon la revendication 1, caractérisé en ce que le substrat sous-jacent (1) est formé d'un matériau choisi dans le groupe comprenant LaAlO₃, NdGaO₃ et MgO.

3. Procédé selon la revendication 1, caractérisé en ce que le substrat sous-jacent (1) est formé d'un matériau choisi dans le groupe comprenant les saphirs et SiO₂, ledit substrat sous-jacent (1) ayant, sur ses surfaces opposées, une couche tampon qui permet de déposer le matière supraconductrice d'oxyde dans de bonnes conditions.

4. Procédé selon la revendication 1, caractérisé en ce que la première couche mince (2a) d'oxyde composite Tl-Ba-Ca-Cu-O formée sur la première surface du substrat sous-jacent (1) et la deuxième couche mince (2b) d'oxyde composite Tl-Ba-Ca-Cu-O formée sur la deuxième surface du substrat sous-jacent (1) sont déposées en continu par pulvérisation à une température du substrat extrêmement basse dans la même chambre de dépôt sans retirer le substrat sous-jacent de ladite chambre de dépôt.
